(19) Europäisches Patentamt
European Patent Office
Office européen des brevets

(11) EP 2 119 810 A2

(12) EUROPÄISCHE PATENTANMELDUNG

(43) Veröffentlichungstag:
18.11.2009 Patentblatt 2009/47

(51) Int Cl.:
C23C 14/35 (2006.01)

(21) Anmeldenummer: 09158570.3

(22) Anmeldetag: 15.12.1998

(84) Benannte Vertragsstaaten:
AT BE CH CY DE DK ES FI FR GB GR IE IT LI LU
MC NL PT SE

(30) Priorität: 17.12.1997 CH 289797

(62) Dokumentnummer(n) der früheren Anmeldung(en)
nach Art. 76 EPÜ:
98958140.0 / 1 042 526

(71) Anmelder: Oerlikon Trading AG, Trübbach
9477 Trübbach (CH)

(72) Erfinder:
• Haag, Walter
9472 Grabs (CH)
• Gruenenfelder, Pius
7323 Wangs (CH)

• Schwendener, Urs
9470 Buchs (CH)
• Schlegel, Markus
9478 Azmoos (CH)
• Krassnitzer, Pius
6800 Feldkirch (AT)

(74) Vertreter: Troesch, Jacques J.
Troesch Scheidegger Werner AG
Schwäntenmos 14
8126 Zumikon (CH)

Bemerkungen:
Diese Anmeldung ist am 23-04-2009 als
Teilanmeldung zu der unter INID-Code 62 erwähnten
Anmeldung eingereicht worden.

(54) **Magnetronsputterquelle**

(57) Magnetronsputterquelle, wobei mindestens zwei elektrisch voneinander isolierte Langtarget-Anordnungen (3) längsseits nebeneinander angeordnet sind, in einem Abstand (d), der wesentlich kleiner ist als die Breitenausdehnung (B) der Targetanordnungen (3), wobei jede der Targetanordnungen (3) einen eigenen elektrischen Anschluss (5) aufweist, wobei weiter eine Anodenanordnung (7) vorgesehen ist, und wobei die Anodenanordnung vorzugsweise Anoden längsseits zwischen den Targetanordnungen umfasst.

FIG.1

**Beschreibung**

Die vorliegende Erfindung betrifft eine Magnetronsputterquelle gemäss Anspruch 1 bzw. 31, eine Vakuumkammer mit einer solchen Quelle nach Anspruch 20, eine Vakuumbehandlungsanlage mit einer solchen Kammer, nach Anspruch 22, weiter ein Betriebsverfahren für eine solche Anlage nach Anspruch 27 sowie Verwendungen davon.

Grundsätzlich geht die vorliegende Erfindung vom Bedürfnis aus, grossflächige, insbesondere rechteckige Substrate mit einer zu beschichtenden Fläche von mindestens 900 cm$^2$ mit homogener Schichtdickenverteilung sputterzubeschichten, dabei insbesondere auch reaktiv. Derartige Substrate werden insbesondere für die Herstellung von Flachbildschirmen, in der Regel auf dünnen Glassubstraten, dünner als 1 mm, basierend, eingesetzt, so insbesondere für TFT-Pannels oder für Plasma Display Pannels (PDP).

Beim Magnetron-Sputterbeschichten grosser Flächen sind üblicherweise noch grössere Sputterflächen und damit Targets nötig, es sei denn, Sputterquelle und Substrat werden relativ zueinander bewegt. Dabei treten Probleme auf bezüglich

(a) Gleichförmigkeit der Prozessbedingungen am grossflächigen Target, ganz ausgeprägt bei reaktivem Sputterbeschichten

(b) Erosionsprofil

(c) Kühlung

(d) Belastung im wesentlichen durch Atmosphären-Druck und Kühlmitteldruck der grossen Targets.

Um das mechanische Belastungsproblem (d) zu lösen, müssen relativ dicke Targetplatten eingesetzt werden, was den Magnetfeld-Durchgriff reduziert und damit den Elektronenfallen-Effekt bei gegebener eingespiesener elektrischer Leistung. Wird aber diese erhöht, so ergeben sich Kühlprobleme (c). Dies vor allem, weil grossflächige Targets nur mit grossem Aufwand gut mit einem Kühlmedium kontaktiert werden können, auch weil dem Target rückseitige Einbauten für Magnete hinderlich entgegenstehen. Weiter ist es bekannt, dass beim Magnetronsputtern, reaktiv oder nicht reaktiv, die Targetanordnung, üblicherweise bestehend aus einer die Sputterfläche definierenden Targetplatte aus zu sputterndem Material und einer daran angebondeten Trägerplatte, entlang sogenannten "race tracks" sputtererodiert wird. An der Sputterfläche entstehen ein oder mehrere umlaufende Erosionsgraben, bedingt durch die angelegten, am Target tunnelförmig entlang gegebener Bahnen erzeugten Magnetfelder, die umlaufende Zonen erhöhter Plasmadichte erzeugen. Diese ergeben sich aufgrund der hohen Elektronendichte im Bereich der tunnelförmig umlaufenden Magnetron-Magnetfelder (Elektronenfallen). Durch diese "race tracks" ergibt sich bereits an relativ kleinflächigen, vor der Magnetronsputterquelle angeordneten, zu beschichtenden Substraten eine inhomogene Schichtdickenverteilung. Zudem wird das Targetmaterial schlecht ausgenützt, denn die Sputtererosion entlang den "race tracks" lässt Targetbereiche ausserhalb dieser tracks weniger abgesputtert, was ein wellen- bzw. grabenförmiges Erosionsprofil ergibt. Aufgrund der "race tracks" bleibt die tatsächlich sputternde Fläche auch eines grossflächigen Targets gegenüber der Substratfläche klein.

Wohl könnte man, zur Eliminierung der Auswirkungen der erwähnten "race tracks" an der Beschichtung, Sputterquelle und zu beschichtendes Substrat wie erwähnt relativ zueinander bewegen, was aber zu einer pro Zeiteinheit reduzierten Beschichtungsrate führte. Wiederum stünden dem Betrieb mit örtlich höherer Sputterleistung bei relativ bewegten Systemen Kühlprobleme entgegen.

Grundsätzlich bestehen somit für das angestrebte Ziel die vier Problemkreise (a), (b) und (c), (d), deren separate Lösungen jeweils verschärfte Probleme bezüglich der anderen nach sich ziehen; die Lösungen laufen sich zuwider.

Die vorliegende Erfindung setzt sich zum Ziel, eine Magnetronsputterquelle zu schaffen, mittels welcher die obgenannten Probleme behoben werden und die sich praktisch zu beliebiger Grösse ausbauen lässt und die ermöglicht, insbesondere eine homogene Beschichtungsdicken-Verteilung an mindestens einem bezüglich Quelle stationären, grossflächigen Substrat wirtschaftlich sicherzustellen. Die Quelle soll weiter, bei hoher Gleichförmigkeit der Prozessbedingungen, darauf empfindliche reaktive Prozesse bei hohen Abscheidungs- bzw. Beschichtungsraten zulassen. Inhomogene "race tracks"-Auswirkungen führen bei reaktiven Prozessen wegen der grossen Plasmadichte-Gradienten wie bekannt zu ausgeprägten Problemen.

Dies wird durch die erfindungsgemässe Magnetronsputterquelle erreicht, bei der mindestens zwei, vorzugsweise mehr als zwei, elektrisch voneinander isolierte Langtarget-Anordnungen längsseitig nebeneinander angeordnet sind, mit einem Abstand, der wesentlich kleiner ist als die Breitenausdehnung der Targetanordnungen, und dass jede der Targetanordnungen einen eigenen elektrischen Anschluss aufweist, wobei weiter eine Anodenanordnung vorgesehen ist. Die Targets der Targetanordnungen sind bevorzugt an den Ecken abgerundet, den "race tracks"-Bahnen folgend.

An einer solchen erfindungsgemässen Magnetronsputterquelle kann mit je unabhängig voneinander eingestellter elektrischer Speisung der einzelnen Targetanordnungen die an einem darüberliegenden Substrat abgelegte Schichtdicken-Verteilung bereits wesentlich verbessert werden. Dabei kann die erfindungsgemässe Quelle modular an beliebige Grössen zu beschichtender Substrate angepasst werden.

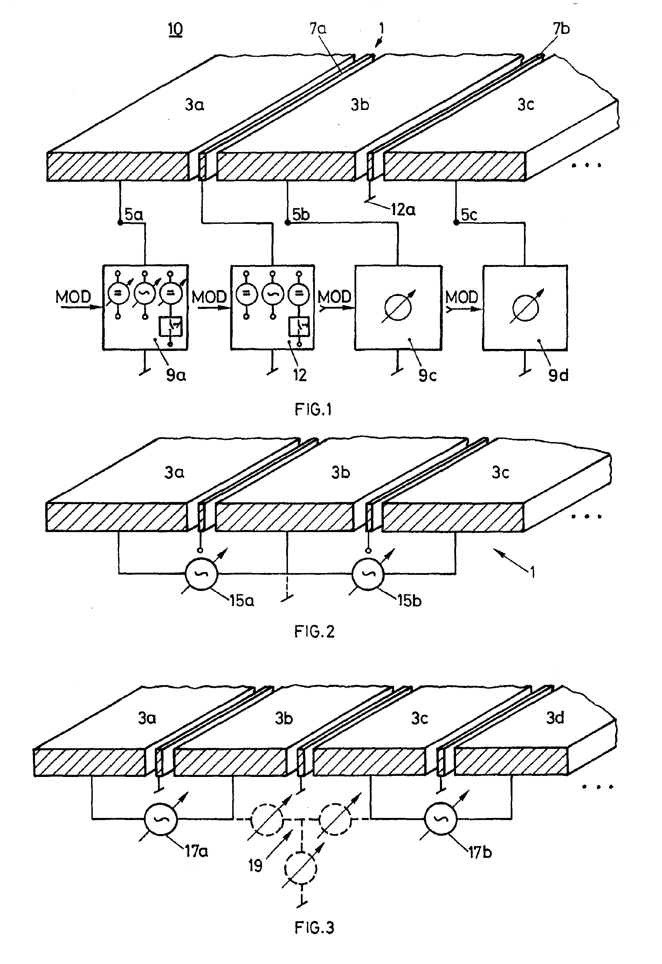

Die Anodenanordnung kann - falls nicht zeitweise durch Targetanordnungen selber gebildet, vergleiche Betrieb nach Figur 2 oder 3 - bezüglich der Gesamtanordnung aussenliegend vorgesehen sein, umfasst aber weit bevorzugt Anoden längsseits zwischen den Targetanordnungen und/oder stirnseits der Targetanordnungen, bevorzugt insbesondere längsseits.

Bevorzugt ist weiter an der Quelle eine stationäre Magnetanordnung vorgesehen; diese wird vorzugsweise durch einen um die Targetanordnungen gemeinsam umlaufenden Magnetrahmen oder, besonders bevorzugt, durch je um die Targetanordnungen umlaufende Rahmen gebildet. Obwohl es durchaus möglich und sinnvoll sein kann, die Magnete am oder an den Rahmen bzw. an der stationären Magnetanordnung mindestens zum Teil durch ansteuerbare Elektromagnete zu realisieren, werden die Magnete der Anordnung bzw. des bzw. der Rahmen bevorzugt durch Permanentmagnete realisiert.

Durch die jeweilige Auslegung der erwähnten stationären Magnetanordnung, vorzugsweise der Permanentmagnet-Rahmen, was das durch sie erzeugte Magnetfeld an den unmittelbar benachbarten Targetanordnungen anbelangt, kann zusätzlich, durch gezielte Formung der "race tracks", die erwähnte Schichtdicken-Verteilung am Substrat und zudem der Ausnützungsgrad der vorgesehenen Langtargets weiter verbessernd beeinflusst werden.

Weiter sind bevorzugt unterhalb jeder der mindestens zwei Targetanordnungen Magnetanordnungen vorgesehen. Diese können durchaus örtlich stationär und zeitlich fix ausgebildet sein, um das tunnelförmige Magnetfeld an je den Targetanordnungen zu bilden. Weiter bevorzugt sind sie so ausgebildet, dass sie eine zeitliche Variation des Magnetfeldmusters an den Targetanordnungen bewirken. Bezüglich Ausbildung und Erzeugung der Magnetfeldmuster, erfindungsgemäss je an den Targetanordnungen, wird auf die EP-A-0 603 587 bzw. die US-A-5 399 253 derselben Anmelderin verwiesen, deren diesbezüglicher Offenbarungsgehalt zum integrierten Bestandteil der vorliegenden Beschreibung erklärt wird.

Wohl kann, gemäss Fig. 2 der EP-A-0 603 587, die Lage des Magnetfeldmusters und damit der Zonen hoher Plasmadichte als Ganzes verändert werden, weitaus bevorzugt wird diese aber nicht oder nur unwesentlich verändert, hingegen, gemäss den Fig. 2 und 3 der erwähnten Schrift, die Lage des Scheitels - der Ort höchster Plasmadichte - verändert.

Jedenfalls können für die Lageveränderung der Zonen bzw. der Scheitel an den Magnetanordnungen je unterhalb der Targetanordnungen, selektiv angesteuerte Elektromagnete, örtlich stationär oder bewegt, vorgesehen sein, weitaus bevorzugt ist diese Magnetanordnung durch getrieben bewegte Permanentmagnete realisiert.

Eine bevorzugte, bewegte Magnetanordnung wird durch mindestens zwei sich unter den Targetanordnungen längserstreckende, getrieben und drehgelagerte Magnetwalzen realisiert, wiederum bevorzugt mit Permanentmagneten, wie dies, an einem Einzeltarget, die Fig. 3 und 4 der EP-A-0 603 587 zeigen.

Die Magnetwalzen werden dabei im Pendelbetrieb angetrieben, mit

Pendelamplitude vorzugsweise $\leq \tau/4$. Bezüglich dieser Technik und ihrer Effekte wird wiederum vollumfänglich auf die erwähnte EP 0 603 587 bzw. die US-A-5 399 253 verwiesen, welche auch diesbezüglich zum integrierten Bestandteil der vorliegenden Anmeldungsbeschreibung erklärt werden.

Es werden somit bevorzugt jeweils mindestens zwei sich entlang der Targetanordnungs-Längsausdehnung erstreckende, angetriebene und drehgelagerte Permanentmagnet-Walzen vorgesehen.

Es wird in bevorzugter Art und Weise

- mit der elektrischen Targetanordnungs-Speisung

- mit dem Feld der erwähnten stationären Magnetanordnung, insbesondere der erwähnten Rahmen

- mit der Feld-zeitvariierenden Magnetanordnung je unter den Targetanordnungen, vorzugsweise den Magnet-Walzen

ein Satz von Beeinflussungsgrössen bereitgestellt, welcher, in Kombination, eine weitestgehende Optimierung der abgelegten Schichtdichten-Verteilung erlaubt, insbesondere deren Homogenisierung. Zusätzlich wird ein hoher Targetmaterial-Ausnützungsgrad erreicht. Höchst vorteilhaft ist, dass bevorzugt - mit Scheitelverschiebung des Magnetfeldes an den Targetanordnungen - nicht die Plasmazonen scannend verschoben werden, sondern innerhalb der Zonen die Plasmadichteverteilung wobbelnd verändert wird.

Um weiter möglichst hohe Sputterleistungen anlegen zu können, werden die Targetanordnungen dadurch bestmöglich gekühlt, dass sie an einem Trägersockel montiert sind, woran deren sockelseitige Flächen zu einem überwiegenden Teil bedeckende, gegen die genannte Fläche mittels Folien verschlossene Kühlmedium-Kanäle angeordnet sind. Dadurch wird eine grossflächige Wärmeabführung möglich, indem sich, Kühlmediumdruck-bedingt, die erwähnten Folien mit Druck satt und flächig an die zu kühlenden Targetanordnungen anlegen und anpressen.

Bevorzugterweise wird an der erfindungsgemässen Magnetronsputterquelle ein Trägersockel, vorzugsweise mindestens teilweise aus einem elektrisch isolierenden Material, vorzugsweise aus Kunststoff, vorgesehen, woran, nebst den erwähnten Targetanordnungen, Anoden sowie, falls vorhanden, die stationäre Magnetanordnung, vorzugsweise Permanentmagnet-Rahmen, die Magnetanordnung unter den Targetanordnungen, vorzugsweise die beweglichen Permanentmagnet-Anordnungen, insbesondere die erwähnten Walzen, sowie die Kühlmediums-Kanäle aufgenommen sind. Dabei ist der Trägersockel so ausgebildet und montiert, dass er Vakuumatmosphäre und Aussenatmosphäre trennt. Dies erlaubt es, die Targetanordnung bezüglich druckbedingter mechanischer Belastung flexibler auszulegen.

Eine weitere Optimierungs- bzw. Stellgrösse für die erwähnte grossflächige Beschichtungsdickenverteilung ergibt sich dadurch, dass, verteilt entlang den Targetanordnungs-Längsseiten, Gasaustritts-Öffnungen vorgesehen sind, welche mit einem Gasverteilsystem kommunizieren. Dadurch wird die Möglichkeit geschaffen, Reaktivgas und/oder Arbeitsgas mit gezielt eingestellter Verteilung in den über der erfindungsgemässen Quelle vorgesehenen Prozessraum einer erfindungsgemässen Vakuumbehandlungs-Kammer bzw. -Anlage einzubringen.

Die Recktecktarget-Anordnungen sind bevorzugterweise um höchstens 15 %, vorzugsweise höchstens um 10 %, vorzugsweise gar höchstens um 7 % ihrer Breitenausdehnung voneinander beabstandet.

Bei einer bevorzugten Ausführungsform beträgt der seitliche Abstand zwischen den einzelnen Targetanordnungen d

$$1 \; mm \leq d \leq 230 \; mm,$$

dabei bevorzugterweise

$$7 \; mm \leq d \leq 20 \; mm.$$

Die Breite B der einzelnen Targetanordnungen beträgt vorzugsweise

$$60 \; mm \leq B \leq 350 \; mm,$$

dabei vorzugsweise

$$80 \; mm \leq B \leq 200 \; mm$$

und ihre Länge L vorzugsweise

$$400 \; mm \leq L \leq 2000 \; mm.$$

Dabei ist die Längsausdehnung der einzelnen Targetanordnungen mit Bezug auf ihre Breitenausdehnung mindestens gleich, vorzugsweise wesentlich länger. Obwohl die Sputterflächen der einzelnen Langtarget-Anordnungen, für sich eben oder bereits vorprofiliert, bevorzugterweise entlang einer Ebene angeordnet sind, ist es durchaus möglich, insbesondere die seitlichen Sputterflächen näher an das zu beschichtende Substrat als die mittleren anzuordnen, gegebenenfalls auch geneigt, um - falls noch nötig - Randeffekte auf die Beschichtungsdickenverteilung zusätzlich zu kompensieren.

Die Elektronen des Magnetronplasmas laufen entlang der "race tracks" in einer durch Magnetfeld und elektrisches Feld im Targetoberflächenbereich festgelegten Richtung um. Es wurde nun erkannt, dass die Führung der Elektronenbahn bzw. deren Beeinflussung und damit die Beeinflussung der entstehenden Erosionsgräben an den Targetoberflächen dadurch gezielt optimiert werden kann, dass das vorgesehene Magnetfeld entlang der Targetanordnungs-Längsausdehnungen, d.h. nicht nur zeitlich variierend, sondern örtlich unterschiedlich ausgebildet wird. Bei vorzugsweise vorgesehenen Magnet-Rahmen - vorzugsweise je einer, weiter vorzugsweise je ein Permanentmagnet-Rahmen - wird dies jedenfalls durch die Positionierung und/oder die gewählte Stärke der am Rahmen vorgesehenen Magnete realisiert und/oder, bei Vorsehen der Magnetanordnung je unterhalb der Targetanordnungen, vorzugsweise den erwähnten Permanentmagnet-Walzen, durch entsprechend variierte Stärke und/oder Relativposition von Magneten an der Magnetanordnung. Weil die Elektronen sich entsprechend der Magnetfeld-Polung in einer gegebenen Umlaufrichtung bewegen, wurde beobachtet, dass offenbar aufgrund von Abdriftkräften die Elektronen insbesondere in den Schmalseitenbereichen der Targetanordnungen und entsprechend ihrer Bewegungsrichtung, an Bereichen sich diagonal gegenüberliegender Eckpartien nach aussen gedrängt werden. Es wird deshalb, besonders bevorzugt, vorgeschlagen, bei vorgesehenen Magnet-Rahmen, die von den Rahmenmagneten erzeugte Feldstärke spiegelsymmetrisch zur Target-"Rechteck"-Diagonale örtlich unterschiedlich auszubilden.

In einer bevorzugten Ausführungsform der erfindungsgemässen Quelle sind die Targetanordnungen mittels linearer Bajonettverschlüsse gehaltert, dies insbesondere in Kombination mit ihrer Kühlung über druckbeaufschlagte Folien obenerwähnter Art. Damit können die Anordnungen, nach Druckentlastung der Kühlmedium-Kanäle, höchst einfach ersetzt werden, der weitaus überwiegende Anteil der Targetanordnungs-Rückseite bleibt für das Kühlen frei, und es liegen keine Befestigungsorgane für die Targetanordnungen gegen den Prozessraum frei.

Eine bevorzugte erfindungsgemässe Quelle weist mehr als zwei Targetanordnungen auf, bevorzugterweise fünf und mehr.

Durch Einsatz einer erfindungsgemässen Magnetronsputterquelle an einer Sputterbeschichtungskammer, woran, diesbezüglich beabstandet, ein Substratträger für mindestens ein sputterzubeschichtendes, vorzugsweise planes Substrat vorgesehen ist, wird es möglich, ein optimal kleines Verhältnis $V_{QS}$ zwischen gesputterter Quellenflächen $F_Q$ und zu beschichtender Substratoberfläche $F_S$ zu realisieren, für welches gilt:

$$V_{QS} \leq 3,$$

vorzugsweise

$$V_{QS} \leq 2,$$

dabei insbesondere bevorzugt

$$1,5 \leq V_{QS} \leq 2.$$

Damit wird der Nutzwirkungsgrad der Quelle wesentlich erhöht. Dies wird im weiteren an einer erfindungsgemässen Sputterbeschichtungskammer mit der erwähnten Quelle in noch weiterem Masse dadurch erreicht, dass der Abstand D zwischen der Neufläche der Magnetronsputterquelle und dem Substrat im wesentlichen gleich der Breite einer der Langtargetanordnungen gewählt wird, vorzugsweise zu

$$60 \text{ mm} \leq D \leq 250 \text{ mm},$$

vorzugsweise zu

$$80 \text{ mm} \leq D \leq 160 \text{ mm}.$$

An einer erfindungsgemässen Vakuumbeschichtungsanlage mit der erwähnten erfindungsgemässen Sputterbeschichtungskammer und damit der erfindungsgemässen Magnetronsputterquelle, sind die Targetanordnungen je mit einem elektrischen Generator bzw. Stromquellen verbunden, welche Generatoren unabhängig voneinander ansteuerbar sind.

In einer weiteren Aufführungsform, oder gegebenenfalls, bei Vorsehen mehrerer Targetanordnungen kombiniert mit der vorerwähnten Generatoranordnung, können mindestens zwei der vorgesehenen Targetanordnungen mit den Ausgängen eines gemeinsamen AC-Generators verbunden sein.

Die Generatoren zur jeweils unabhängigen elektrischen Speisung der Targetanordnungen können "artrein" DC-Generatoren, AC-Generatoren, Generatoren für die Erzeugung überlagerter DC- und AC-Signale oder gepulster DC-Signale sein, wobei insbesondere bei DC-Generatoren zwischen Generator und jeweiliger Targetanordnung eine Choppereinheit vorgesehen werden kann, mittels welcher die Targetanordnung, getaktet auf den Generatorausgang oder niederohmiger, auf ein Bezugspotential des Generators gelegt wird. Bezüglich dieser Technik wird vollumfänglich auf die EP-A-0 564 789 bzw. die US-Anmeldung Nr. 08/887 091 derselben Anmelderin verwiesen.

Im weiteren sind längsseits der Targetanordnungen vorgesehene Gasauslassöffnungen mit einem Reaktivgastank und/oder einem Arbeitsgastank, wie für Argon, verbunden, und es können bevorzugterweise die Gasauslässe entlang verschiedener Targetanordnungs-Längsseiten bezüglich Gasfluss unabhängig voneinander eingestellt werden.

Die erfindungsgemässe Sputterbeschichtungsanlage mit mindestens drei Langtarget-Anordnungen wird bevorzugterweise so betrieben, dass die seitlich aussenliegenden Targetanordnungen mit 5 bis 35 % mehr Sputterleistung betrieben werden, vorzugsweise mit 10 bis 20 %, als die innenliegenden Targetanordnungen. Das oben erwähnte "Scannen" der Targetanordnungen bezüglich Lage der Plasmazonen und insbesondere das bevorzugte "Wobbeln" der Scheitellage der Tunnel-Magnetfelder und damit der Plasmadichte-Verteilung, insbesondere bevorzugt realisiert mittels der erwähnten Magnet-Walzen, im Pendelbetrieb, erfolgt vorzugsweise mit einer Frequenz von 1 bis 4 Hz, vorzugsweise von ca. 2 Hz. Dabei beträgt die Walzen-Pendelamplitude vorzugsweise $\varphi \leq \pi/4$. Durch gezielte Auslegung der Weg/ Zeit-Profile für die erwähnte Lageverschiebung wird die Beschichtungsdicken-Verteilung am Substrat noch weiter optimiert.

Dabei ist zu betonen, dass hierfür auch die an die Targetanordnungen aufgeschalteten Generatoren zur Abgabe in der Zeit und in gegenseitiger Abhängigkeit modulierter Ausgangssignale angesteuert werden können.

Im weiteren wird die elektrische Speisung der Targetanordnungen und/oder der verteilte Gaseinlass und/oder die Magnetfeldverteilung so gesteuert oder in der Zeit moduliert, dass am Substrat eine erwünschte Schichtdickenverteilung resultiert, vorzugsweise eine homogene.

Die Magnetronsputterquelle wird vorzugsweise mit einer Leistungsdichte p von

$$1 \ W/cm^2 \leq p \leq 30 \ W/cm^2,$$

dabei insbesondere zum reaktiven Ablegen von Schichten vorzugsweise aus metallischen Targets, dabei insbesondere ITO-Schichten mit

$$1 \ W/cm^2 \leq p \leq 5 \ W/cm^2$$

und zum Sputterbeschichten von Metallschichten vorzugsweise mit

$$15 \ W/cm^2 \leq p \leq 30 \ W/cm^2$$

betrieben.

Wie im Zusammenhang mit der Entwicklung der vorerwähnten, erfindungsgemässen Magnetronsputterquelle erkannt wurde, ist es insbesondere bei Targetplattenanordnungen, welche wesentlich länger als breit sind, grundsätzlich vorteilhaft, die Magnetfeldstärke des Magnetronfeldes, betrachtet in Längsrichtung der Targetanordnungen und insbesondere in deren Seitenbereich örtlich unterschiedlich auszubilden.

Diese Erkenntnis ist aber für Langmagnetrons grundsätzlich anwendbar.

Deshalb wird für eine erfindungsgemässe Langmagnetronquelle, welche darunter ein zeitlich variables, vorzugsweise bewegtes Magnet-System, vorzugsweise Permanentsystem umfasst, vorgeschlagen, der Targetanordnung einen Magnet-Rahmen zuzuordnen, vorzugsweise einen Permanentmagnet-Rahmen und dabei, in einer gegebenen Raumrichtung gemessen, die Feldstärke der Rahmen-Magnete entlang den Targetanordnungs-Längsseiten örtlich unterschiedlich auszubilden. Zur Kompensation der erwähnten, auf die umlaufenden Elektronen wirkenden Abdriftkräfte, wird dabei vorgeschlagen, diese Feldstärke im wesentlichen spiegelsymmetrisch zur Targetdiagonale örtlich unterschiedlich auszubilden.

Die vorliegende Erfindung unter all ihren Aspekten eignet sich insbesondere für das Sputterbeschichten von Substraten, insbesondere von grossflächigen und dabei vorzugsweise planen Substraten durch einen reaktiven Prozess, vorzugsweise ab metallischen Targets, vorzugsweise mit einer ITO-Schicht (Indium-Zinn-Oxid). Die Erfindung eignet sich weiter insbesondere für die Beschichtung von Substraten, insbesondere Glassubstraten, im Rahmen der Herstellung von Flachpannel-Displays, insbesondere von TFT- oder PDP-Pannels, wobei grundsätzlich die Möglichkeit eröffnet wird, Grossubstrate, beispielsweise auch Halbleitersubstrate, höchst rationell und mit geringsten Ausschussquoten reaktiv oder nicht reaktiv sputterzubeschichten, aber insbesondere eben auch reaktiv.

Gerade bei reaktiven Sputterbeschichtungsprozessen, insbesondere bei ITO-Beschichtung, sind niedere Entladespannungen für das Erreichen hoher Schichtqualität, dabei insbesondere tiefe Schichtwiderstände, auch ohne Temperschritt wesentlich. Dies wird durch die erfindungsgemässe Quelle erreicht.

Dabei wird auch wirksam eine Unterdrückung von Arc-Entladungen realisiert.

Die Erfindung wird anschliessend anhand von Figuren beispielsweise erläutert. Es zeigen:

Fig. 1    eine erfindungsgemässe Magnetronsputterquelle, elektrisch in einer ersten Variante betrieben;

Fig. 2    schematisch die erfindungsgemässe Sputterquelle nach Fig. 1 in einer weiteren elektrischen Beschaltungskonfiguration;

Fig. 3    eine weitere elektrische Beschaltungskonfiguration der erfindungsgemässen Sputterquelle, dargestellt in Analogie zu Fig. 1;

Fig. 4    einen Ausschnitt einer erfindungsgemässen Magnetronsputterquelle in Querschnitts-Darstellung;

Fig. 5    in Aufsicht einen linearen Bajonettverschluss, wie er bevorzugt an der Quelle gemäss Fig. 4 eingesetzt wird,

Fig. 6    vereinfacht eine Aufsicht auf einen Ausschnitt einer erfindungsgemässen Magnetronquelle;

Fig. 7    eine Aufsicht auf eine bevorzugte Ausführungsform einer an der erfindungsgemässen Magnetronsputterquelle gemäss Fig. A bevorzugterweise vorgesehenen Permanentmagnet-Walze;

Fig. 8    schematisch eine erfindungsgemässe Sputterbeschichtungs-Anlage;

Fig. 9    ein Erosionsprofil an einer der Targetanordnungen der erfindungsgemässen Quelle;

Fig. 10   an einer erfindungsgemässen Quelle mit fünf Targetanordnungen ermittelt, die Verteilung des von der Quelle abgesputterten Materials;

Fig. 11   ein Schichtdicken-Relief an einem 530 x 630 mm$^2$-Glassubstrat, beschichtet mit einer erfindungsgemässen Quelle.

In Fig. 1 ist schematisch eine erfindungsgemässe Magnetronsputterquelle 1 in ihrer Grundkonfiguration dargestellt. Sie umfasst mindestens zwei, wie dargestellt beispielsweise drei, Langtarget-Anordnungen 3a bis 3c. Die an einer Magnetronsputterquelle bekanntlich vorzusehenden weiteren Aggregate, wie Magnetfeldquellen, Kühleinrichtungen etc., sind in Fig. 1 nicht dargestellt. Die Quelle 1 weist an jeder der Targetanordnungen 3 einen eigenen elektrischen Anschluss 5 auf. Vorzugsweise zwischen den längsseits voneinander beabstandeten Targetanordnungen 3 sind, z.B. leistenförmig, Anoden 7a, 7b vorgesehen.

Dadurch, dass die Targetanordnungen 3 elektrisch voneinander isoliert sind und je elektrische Anschlüsse 5 aufweisen, wird ihre unabhängige elektrische Beschaltung, wie anschliessend auch im Zusammenhang mit den Fig. 2 und 3 beschrieben wird, möglich.

Gemäss Fig. 1 wird jede der Targetanordnungen 3 auf einen Generator 9 geschaltet, welche Generatoren unabhängig voneinander ansteuerbar sind und welche auch nicht zwingend derselben Gattung angehören müssen. Wie schematisch dargestellt, können alle Generatoren, oder gegebenenfalls gemischt, durch DC-Generatoren, AC-Generatoren, AC- und DC-Generatoren, Generatoren zur Abgabe gepulster DC-Signale oder als DC-Generatoren mit zwischen Generatorausgang und der jeweiligen Targetanordnung vorgesehenen Choppereinheitein ausgebildet sein, bezüglich deren Aufbau und Wirkungsweise vollumfänglich auf die erwähnte EP-A-0 564 789 bzw. US-Anmeldung Nr. 08/887 091 verwiesen wird.

Auch die Anoden 7 können frei wählbar elektrisch betrieben werden. Dies, indem sie, wie mit dem Generator 12 dargestellt, z.B. auf DC-, AC- oder DC- mit überlagertem AC oder gepulste DC-Spannung, ggf. wiederum über eine der erwähnten Choppereinheiten, betrieben werden, oder, wie bei 12a dargestellt, auf Bezugspotential gelegt werden. Durch Variation des elektrischen Kathoden-, d.h. Targetanordnungs-Betriebes, und ggf. zusätzlich des elektrischen Anodenbetriebes, verteilt über die durch die Targetanordnungen gebildete Quellenfläche, kann gezielt die Verteilung abgesputterten Materials und mithin die Verteilung auf einem über der Quelle angeordneten (nicht dargestellten) Substrat eingestellt werden.

Dabei können die Generatoren 9, in gegenseitiger Abhängigkeit, wie mit den Modulations-Eingängen MOD dargestellt, in der Zeit moduliert werden, um so, gezielt, wanderwellenartig die elektrischen Betriebsverhältnisse über den Targetanordnungen zeitlich zu modulieren.

In den Fig. 2 und 3 sind, unter Beibehalt der Positionszeichen für bereits beschriebene Quellenteile, weitere elektrische Beschaltungsmöglichkeiten der erfindungsgemässen Quelle 1 dargestellt, bei denen (nicht dargestellt) auf eine Anodenanordnung verzichtet werden kann.

Gemäss den Fig. 2 und 3 werden Targetanordnungen 3 jeweils paarweise mit den Eingängen von AC-Generatoren 15a, 15b bzw. 17a, 17b verbunden, wobei auch hier die Generatoren 15 bzw. 17 gegebenenfalls AC-überlagerte DC-Signale oder gepulste DC-Signale abgeben können. Wieder werden die Generatoren 15, 17 gegebenenfalls moduliert, z.B. ein AC-Ausgangssignal, praktisch als Trägersignal, mit einer Amplitudenmodulation.

Während gemäss Fig. 2 jeweils eine der Targetanordnungen (3b) mit einem Eingang je eines der Generatoren 15a und 15b verbunden ist, sind die Targetanordnungen 3 gemäss Fig. 3 paarweise über die Generatoren 17 verbunden, wobei es durchaus möglich ist, wie gestrichelt bei 19 dargestellt, im Sinne von "common mode"-Signalen sowohl bei der Ausführung nach Fig. 2 wie auch nach derjenigen von Fig. 3, einzelne Targetanordnungsgruppen gemeinsam auf unterschiedliche Potentiale zu legen. Wird eine Beschaltungstechnik nach Fig. 2 oder 3 gewählt, so werden in bevorzugter Ausführungsform die Generatoren mit einer Frequenz von 12 bis 45 kHz betrieben. Bezüglich eines "common mode"-Potentials, wie beispielsweise das in Fig. 2 eingetrage Massepotential, werden dabei jeweils paarweise an einen Generator geschaltete Targetanordnungen abwechselnd auf positive und negative Potentiale gelegt.

Aus den Darstellungen von Fig. 1 bis 3 ist erkenntlich, dass die erfindungsgemässe Magnetronquelle eine sehr hohe Flexibilität zulässt, die einzelnen Targetanordnungen 3 elektrisch zu betreiben und damit die Verteilung abgesputterten Materials im Prozessraum 10 und an einem Substrat abgelegten Materials gezielt auszulegen.

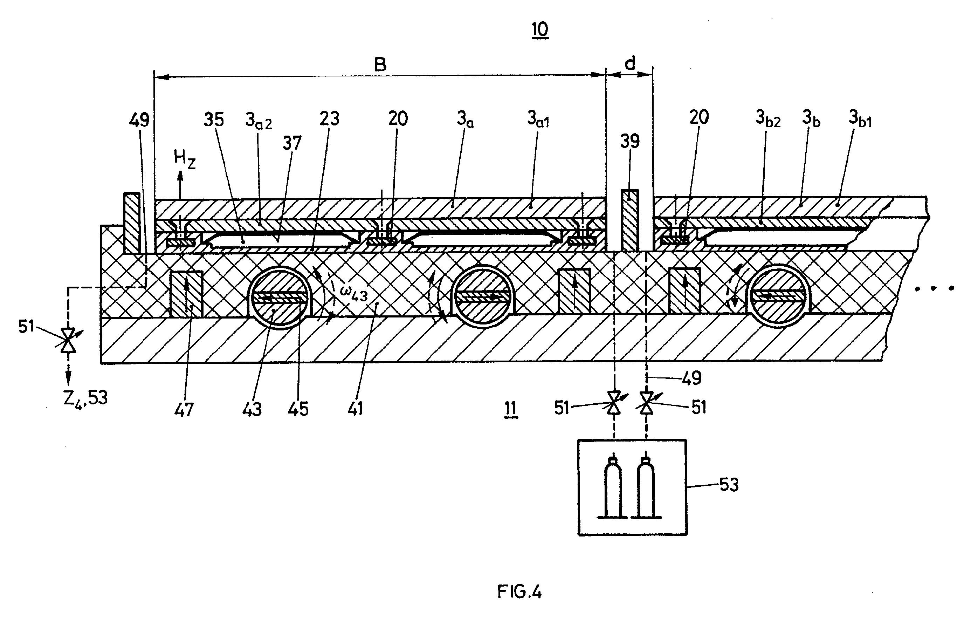

In Fig. 4 ist eine Querschnitts-Darstellung einer erfindungsgemässen Magnetronsputterquelle in einer bevorzugten Ausführungsform ausschnittsweise dargestellt. Gemäss Fig. 4 umfassen die Targetanordnungen je eine Targetplatte $3_{a1}$ bzw. $3_{b1}$ aus zu sputterndem Material, welche je auf eine back-plate $3_{a2}$ bzw. $3_{b2}$ gebondet sind. Mit Hilfe linearer Bajonettverschlüsse 20 sind die Targetanordnungen 3 an ihrer seitlichen Peripherie und/oder in ihrem Zentrumsbereich an einer metallischen Kühlplatte 23 gehaltert.

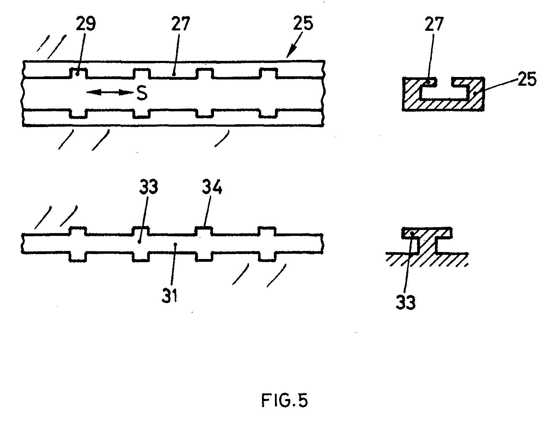

Die Ausbildung der linearen Bajonettverschlüsse ergibt sich aus Fig. 5. Danach ist entweder an der Targetanordnung 3 oder an der Kühlplatte 23 eine Hohlschiene 25 vorgesehen, im Querschnitt U-förmig, mit einwärtsgebogenen U-Schenkeln 27, woran, beabstandet, Einformungen 29 eingearbeitet sind. Am andern der beiden Teile, vorzugsweise an der Targetanordnung 3, ist eine lineare Schiene 31 vorgesehen mit T-Querschnittsform, woran die Endpartien des Querbalkens 33 Ausformungen 34 aufweisen. Durch Einführen der Ausformungen 34 in die Einformungen 29 und lineares Verschieben in Richtung S werden die beiden Teile miteinander verhakt. Selbstverständlich ist es möglich, in Sinne einer Umkehr, an der Hohlschiene Ausformungen vorzusehen, die, entsprechend, in Einformungen an der Schiene 31 eingreifen.

Das Festspannen der Targetanordnungen 3 an der Kühlplatte 23 erfolgt erst durch Unterdrucksetzung eines Kühlmediums in Kühlkanälen 35 in der Kühlplatte 23. Diese Kanäle 35 erstrecken sich entlang des überwiegenden Flächenbereiches der gegen die Kühlplatte 23 hin liegenden Targetanordnungsfläche. Die Kühlkanäle 35, wie erwähnt mit einem unter Druck gesetzten, flüssigen Kühlmedium beaufschlagt, sind gegen die Targetanordnungen 3 hin, wie dies beispielsweise in der CH-A-687 427 derselben Anmelderin ausführlich beschrieben ist, durch eine folienartige Membran 37 dichtend abgeschlossen. Die Folien 37 legen sich, unter Kühlmediumsdruck, satt an die Unterseite der back-plate $3_{a2}$ bzw. $3_{b2}$. Dabei wird erst bei Unterdrucksetzung des Kühlmediums die Targetanordnung unverrückbar im Bajonettverschluss festgespannt. Zur Entfernung der Targetanordnungen 3 wird das Kühlsystem, als Ganzes oder das jeweilige Kühlsystem, druckentlastet, worauf die Targetanordnungen spielend ausgeschoben und entfernt bzw. ausgewechselt werden können.

Längsseits der Targetanordnungen 3 verlaufen Anodenleisten 39. Die Anodenleisten sowie die Kühlplatte 23 sind auf einem Trägersockel 41 montiert, der bevorzugterweise mindestens teilweise aus isolierendem Material, vorzugsweise aus Kunststoff gefertigt ist. Der Sockel 41 trennt die Vakuumatmosphäre im Prozessraum 10 von Umgebungs- bzw. Normalatmosphäre im Raum 11.

Im Trägersockel 41 sind, Atmosphärendruck-seitig, beispielsweise zwei sich über die Längsausdehnung der Targetanordnungen erstreckende Permanentmagnet-Walzen 43 drehbar gelagert und werden (nicht dargestellt) durch Antriebsmotoren pendelnd angetrieben. Sie führen, im Pendelbetrieb, vorzugsweise eine 180°-Drehwinkel-Pendelbewegung - ω43 - aus. In den Permanentmagnet-Walzen 43 sind, entlang ihrer Längsausdehnung, vorzugsweise diametral, Permanentmagnete 45 eingelassen.

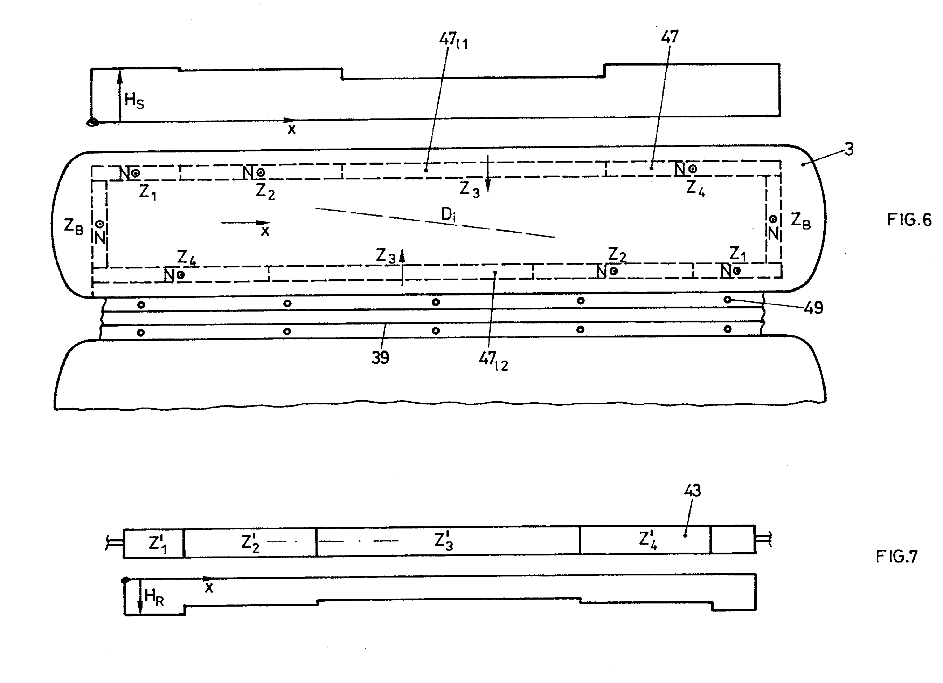

Im Trägersockel 41 ist weiter, wiederum atmosphärenseitig, für jede Targetanordnung 3 je ein Permanentmagnet-Rahmen 47 eingelassen, der im wesentlichen, und wie sich aus Fig. 6 ergibt, unterhalb und entlang dem Peripherieberech der jeweiligen Targetanordnung 3 verläuft.

Insbesondere entlang der Targetanordnungs-Längsseiten münden Gaseinlassleitungen 49 gemäss Fig. 6, und wie in Fig. 4 gestrichelt eingetragen, aus, welche bevorzugterweise je reihenweise bezüglich Gasdurchfluss unabhängig voneinander steuerbar sind. Dies ist in Fig. 4 mit Stellventilen 51 schematisch dargestellt, die in einer Verbindung zwischen den Leitungen 49 und einer Gastankanordnung 53 mit einem Arbeitsgas, wie Argon und/oder mit einem Reaktivgas vorgesehen sind.

Bezüglich dem Betrieb und der Auslegung der Permentmagnet-Walzen 43 wird nochmals vollumfänglich auf den Offenbarungsgehalt der EP-0 603 587 bzw. der US-A-5 399 253 verwiesen.

In Fig. 6 ist vereinfacht und ausschnittsweise eine Aufsicht auf eine erfindungsgemässe Magnetronquelle gemäss Fig. 4 dargestellt. Wie bereits anhand von Fig. 4 dargestellt, ist unter jeder der Targetanordnungen 3 ein Permanentmagnet-Rahmen 47 vorgesehen. Bevorzugterweise ist der Magnetrahmen 47 so ausgebildet, dass, betrachtet in einer Raumrichtung, beispielsweise gemäss $H_Z$ von Fig. 4, das durch den Permanentmagnet-Rahmen erzeugte Magnetfeld sich, wie in Fig. 6 mit x dargestellt, entlang den Längsseiten der Targetanordnungen 3 örtlich ändert. In bevorzugter Ausführungsform sind die an den Längsschenkeln $47l_1$ und $47l_2$ des Rahmens 47 vorgesehenen Magnete in mehrere, wie in Fig. 6 dargestellt beispielsweise in vier, Zonen eingeteilt. Im Diagramm in Fig. 6 ist qualitativ über der Koordinate x die Feldstärke der in den einzelnen Zonen $Z_1$ bis $Z_4$ vorgesehenen Permanentmagnete dargestellt und mithin die Feldstärkenverteilung in Richtung x. Im weiteren sind in den jeweiligen Zonen Z die Permanentmagnet-Dipolrichtungen eingezeichnet.

Bevorzugterweise sind an den Schenkel $47l_{1,2}$ dieselben Permanentmagnet-Zonen vorgesehen, jedoch bezüglich der Diagonale $D_i$ der Langtarget-Anordnung 3 spiegelbildlich.

Durch gezielte Auslegung der örtlichen Magnetfeldverteilung, welche durch die Permanentmagnet-Rahmen 47 an den Targetanordnungen 3 erzeugt werden, wird es möglich, die Bahn der umlaufenden Elektronen zu optimieren und damit Lage und Ausbildung der Erosionsgräben an den einzelnen Targetanordnungen. Dies insbesondere unter Berücksichtigung der durch Abdriftkräfte bewirkten Bahnverformungen. An den Breitseiten der Targetrahmen 47 sind Permanentmagnet-Zonen $Z_B$ vorgesehen, welche bevorzugterweise der Zone $Z_2$ entsprechen. Wie bereits erwähnt, ist auch eine Einzeltarget-Quelle gemäss Fig. 4 und 6 und 7 erfinderisch.

Das örtlich in x-Richtung variierende Magnetfeld H über den jeweiligen Targetanordnungen 3, das zusätzlich, aufgrund der Magnet-Walzen-Pendelbewegung, auch zeitlich variiert, wird durch Wahl der Feldstärke der vorgesehen Permanentmagnete, wie in den Zonen $Z_1$, $Z_2$, $Z_4$ und/oder durch Wahl der räumlichen Dipol-Orientierung, wie in der Zone $Z_3$, und/oder der Lage (Abstand von der Targetanordnung) gezielt ausgelegt.

Wie erwähnt wurde, werden bevorzugterweise an jeder der an der erfindungsgemässen Sputterquelle vorgesehenen Targetanordnungen 3 mindestens zwei Permanentmagnet-Walzen 43 vorgesehen. Eine solche ist in Fig. 7 dargestellt.

Bevorzugterweise werden auch an den Walzen 43 unterschiedliche Permanentmagnet-Zonen, z.B. $Z'_1$ bis $Z'_4$, vorgesehen. In Fig. 7 ist qualitativ der Verlauf des örtlich variierenden Permanentmagnet-Feldes $H_R(x)$ entlang der vorgesehenen Walzen, und wie bevorzugterweise ausgelegt, dargestellt.

An der erfindungsgemässen Quelle wird mithin die örtliche und zeitliche Verteilung der Sputterrate durch gezielte örtliche und/oder zeitliche Verteilung der elektrischen Speisung der einzelnen Targetanordnungen und/oder gezielte örtliche und/oder zeitliche Variation des Magnetron-Magnetfeldes an den einzelnen Targetanordnungen und/oder durch gezielte örtliche und/oder zeitliche Variation bzw. Auslegung der Gaseindüsungs-Verhältnisse an den Einlassöffnungen 49 optimiert. In der bevorzugten Ausführungsform, die anhand der Fig. 4 bis 7 erläutert wurde, werden bevorzugterweise alle diese Grössen kombiniert ausgenützt, um die Beschichtungsdicken-Verteilung an einem sputterzubeschichtenden Substrat, insbesondere einem planen, gezielt auszulegen, insbesondere bevorzugt homogen auszubilden.

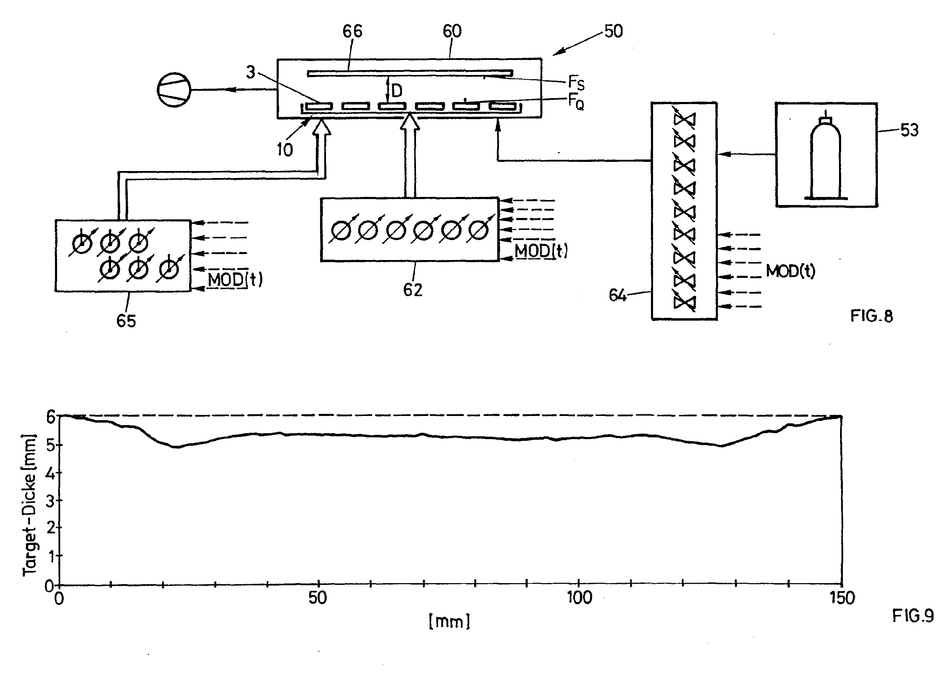

In Fig. 8 ist schematisch eine erfindungsgemässe Sputterbeschichtungsanlage 50 mit einer erfindungsgemässen Sputterbeschichtungskammer 60 dargestellt, darin, ebenfalls schematisch dargestellt, einer erfindungsgemässen Magnetronsputterquelle 10. Die schematisch dargestellte Quelle 10 weist, wie in einer bevorzugten Ausführungsform realisiert, sechs Targetanordnungen 3 auf und ist im weiteren bevorzugterweise ausgebildet, wie anhand der Fig. 4 bis 7 erläutert wurde. Die erfindungsgemässe Quelle mit ihren Targetanordnungen wird durch unabhängige elektrische - gegebenenfalls modulierbare - Speisungen betrieben, wie im Block 62 dargestellt ist. Im weiteren werden die - gegebenenfalls modulierbaren - Gaseindüsverhältnisse insbesondere entlang der Längsausdehnungen der Targetanordnungen, wie mit dem Stellventilblock 64 dargestellt, selektiv eingestellt, um ein Arbeits- und/oder Reaktivgas aus dem Gastank 53 in den Prozessraum einzulassen.

Mit dem Antriebsblock 65 ist der - gegebenenfalls Weg/Zeitmodulierbare - Antrieb für die an der erfindungsgemässen Quelle vorgesehenen Permanentmagnet-Walzen dargestellt, woran, bevorzugt selektiv, die erwünschten Walzen-Pendelbewegungen eingestellt werden können.

In der erfindungsgemässen Kammer 60 ist ein Substratträger 66 vorgesehen, insbesondere zur Aufnahme eines planen, zu beschichtenden Substrates. Aufgrund der durch die erfindungsgemässe Quelle gegebenen Möglichkeiten, die zeitliche und örtliche Verteilung des von der Quelle 10 abgestäubten Materials optimal einzustellen, insbesondere eine über die Zeit gemittelte, gleichförmige Verteilung, insbesondere auch in den Quellenrandbereichen, ist es möglich, das Verhältnis $V_{QS}$ der Sputterfläche $F_Q$ der Quelle zur zu beschichtenden Substrat-Oberfläche $F_S$ überraschend klein auszulegen, vorzugsweise zu

$$V_{QS} \leq 3,$$

vorzugsweise

$$V_{QS} \leq 2,$$

und gar vorzugsweise

$$1,5 \leq V_{QS} \leq 2.$$

Dieses Mass sagt aus, dass das von der Quelle abgestäubte Material mit hohem Wirkungsgrad ausgenützt wird, indem nur entsprechend wenig des abgestäubten Materials nicht auf die zu beschichtende Substratfläche auftrifft. Dies wird insbesondere noch dadurch verstärkt, dass der Abstand D - wegen der grossflächig verteilten Plasmabelegung der Quelle - zwischen sputterzubeschichtender Substratoberfläche und Neufläche der Magnetronquelle 10 klein gewählt werden kann, im wesentlichen gleich der Breite B (siehe Fig. 4) der Sputterflächen der Targetanordnungen 3 und vorzugsweise zu

$$60 \text{ mm} \leq D \leq 250 \text{ mm}$$

vorzugsweise zu

$$80 \text{ mm} \leq D \leq 160 \text{ mm}.$$

Durch die Realisierbarkeit der erwähnten kleinen Abstände D ergibt sich eine hohe Beschichtungsrate bei hoher Zerstäubungsausnutzung, somit eine höchst wirtschaftliche Beschichtung.

An der in Fig. 8 dargestellten Anlage werden mit den Generatoren 62 bevorzugterweise die seitlich äussersten Targetanordnungen mit einer höheren Sputter-Leistung betrieben, vorzugsweise mit 5 bis 35 % mehr, besonders bevorzugt mit 10 bis 20 % mehr Sputterleistung als die weiter innen gelegenen Targetanordnungen. Weiter werden bevorzugterweise die an der Quelle 10 gemäss Fig. 4 vorgesehenen Permanetmagnet-Walzen in einem Pendelbetrieb mit einer Pendelfrequenz von 1 bis 4 Hz, vorzugsweise mit ca. 2 Hz, betrieben.

Die erfindungsgemässe Magnetronsputterquelle, Sputterkammer bzw. Anlage, insbesondere im bevorzugten Betrieb, eignen sich insbesondere zur Magnetron-Sputterbeschichtung grossflächiger, insbesondere planer Substrate, mit einer Beschichtung hoher Qualität, mit erwünschter Verteilung der Beschichtungsdicke, insbesondere mit einer homogenen Dickenverteilung bei hoher Wirtschaftlichkeit. Dies massgeblich basierend auf den grossflächig gleichverteilten Prozessbedingungen an der erfindungsgemässen Quelle. Die Erfindung kann damit für die Beschichtung grossflächiger Halbleiter-Substrate, aber insbesondere für die Beschichtung von Substraten von Flachdisplay-Pannels, insbesondere von TFT- bzw. PDP-Pannel, eingesetzt werden. Dabei wird die Erfindung insbesondere eingesetzt für die reaktive Beschichtung der erwähnten Substrate insbesondere mit ITO-Schichten oder zur Metallbeschichtung der erwähnten Substrate durch nicht reaktives Sputterbeschichten. Es seien nachfolgend beispielsweise bevorzugte Auslegungsgrössen an der erfindungsgemässen Quelle bzw. Kammer bzw. Anlage zusammengestellt.

1. Geometrie

1.1 An der Quelle

- Seitlicher Abstand d gemäss Fig. 4: höchstens 15 %, vorzugsweise höchstens 10 %, vorzugsweise gar höchstens 7 % der Breitenausdehung B der Targetanordnungen und/oder

$$1 \text{ mm} \leq d \leq 230 \text{ mm},$$

vorzugsweise

$$7 \text{ mm} \leq d \leq 20 \text{ mm}.$$

- Neuflächen der Targetanordnungen entlang einer Ebene;
- Breite B der Targetanordnungen:

$$60 \text{ mm} \leq B \leq 350 \text{ mm},$$

vorzugsweise

$$80 \text{ mm} \leq B \leq 200 \text{ mm}.$$

- Länge der Targetanordnungen L: mindestens B, vorzugsweise wesentlich länger, vorzugsweise

$$400 \text{ mm} \leq L \leq 2000 \text{ mm}.$$

- Endbereiche der Targets: z.B. halbkreisförmig.

1.2 Quelle/Substrat:

- Verhältnis $V_{QS}$ der Ausdehnung der Sputterfläche $F_Q$ zu Ausdehnung der zu beschichtenden Substrat-Oberfläche $F_S$:

$$V_{QS} \leq 3,$$

vorzugsweise

$$V_{QS} \leq 2,$$

vorzugsweise gar

$$1,5 \leq V_{QS} \leq 2.$$

- Kleinster Abstand Quellen-Neuflächen/Beschichtungsfläche D:

$$60 \text{ mm} \leq D \leq 250 \text{ mm},$$

vorzugsweise

$$80 \text{ mm} \leq D \leq 160 \text{ mm}.$$

- Substratgrössen: beispielsweise 750 x 630 mm$^2$, beschichtet mit einer Quelle mit einer Sputterfläche von: 920 x 900 mm$^2$, oder
Substratgrösse: 1100 x 900 mm$^2$ mit einer Sputterfläche der Quelle von: 1300 x 1200 mm$^2$.

1.3 Kühlung:

Verhältnis Sputterfläche zu Kühlfläche $V_{SK}$:

$$1,2 \leq V_{SK} \leq 1,5.$$

2. Betriebsgrössen

- Targettemperatur T:

$$40°C \leq T \leq 150°C,$$

vorzugsweise

$$60°C \leq T \leq 130°C.$$

- Sputterleistung pro Sputterflächen-Einheit: 10 bis 30 W/cm$^2$, vorzugsweise 15 bis 20 W/cm$^2$.
- Seitlich äusserste Targetanordnungen jeweils vorzugsweise mit 5 bis 35 % mehr Sputterleistung, vorzugsweise mit 10 bis 20 % mehr Sputterleistung pro Flächeneinheit.

- Pendelfrequenz der Magnetwalzen: 1 bis 4 Hz, vorzugsweise ca. 2 Hz.

Resultate: Es wurden folgende Beschichtungsraten erreicht:

- ITO: 20 Å/sec.

- Al: 130 bis 160 Å/sec.

- Cr: 140 Å/sec.

- Ti: 100 Å/sec.

- Ta: 106 Å/sec.

In Fig. 9 ist das Erosionsprofil an einer 15 cm breiten Sputterfläche einer der Targetanordnungen an der erfindungsgemässen Quelle wiedergegeben. Es ist der äusserst gleichförmige Abtrag erkenntlich, woran die "race tracks" bzw. Erosionsgräben kaum mehr erkenntlich sind.

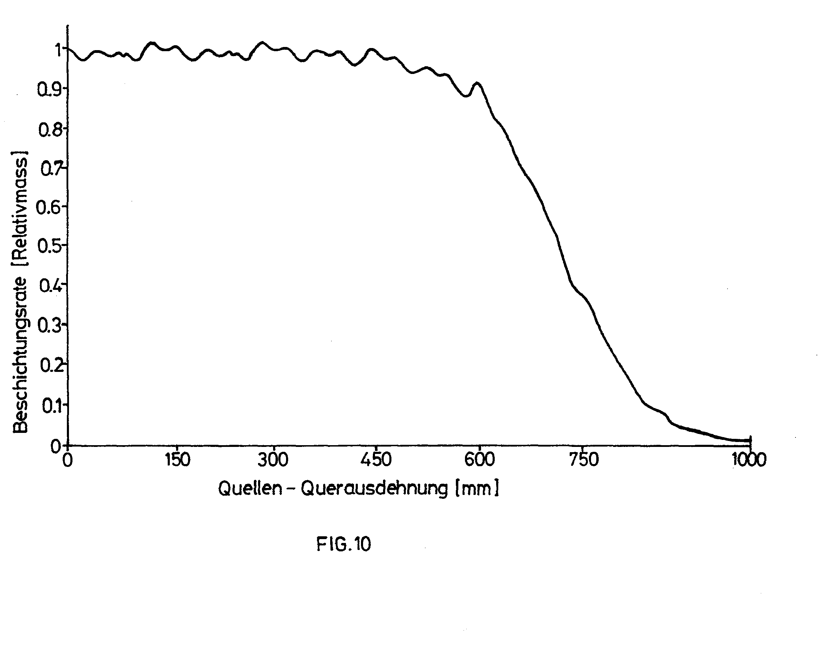

In Fig. 10 ist an einer erfindungsgemässen Quelle mit fünf Targetanordnungen, je mit Sputterflächen einer Breite B von 150 mm, die resultierende Beschichtungsraten-Verteilung bei ITO-Sputterbeschichten dargestellt. Bei dieser Verteilung ergaben sich an einem Substrat, angeordnet in einer Distanz D von 120 mm von der Quellenfläche, Schicht-dicken-Abweichungen von nurmehr $\pm$ 3,8 %.

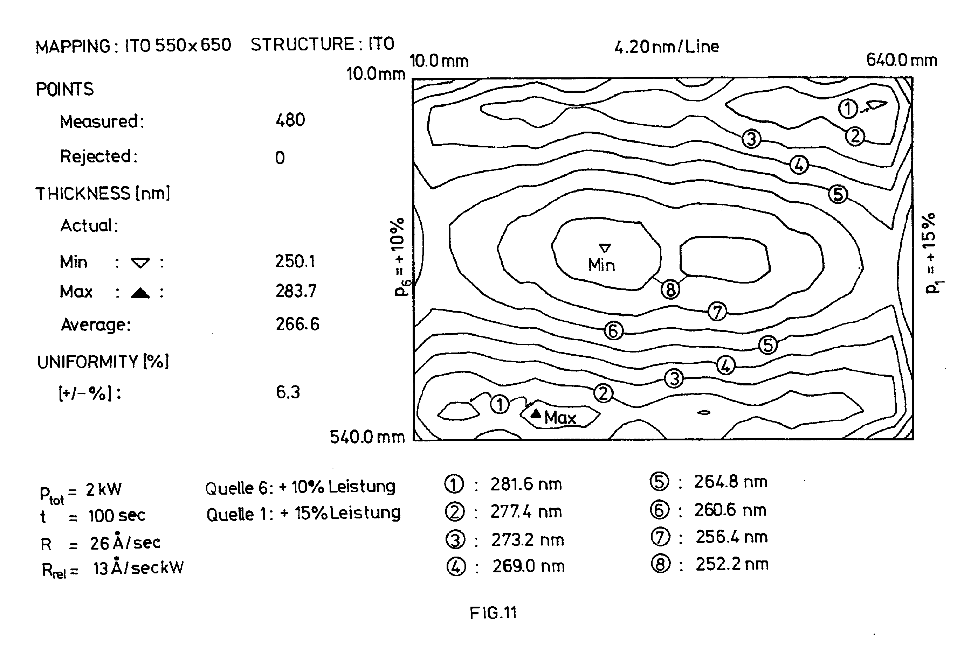

In Fig. 11 ist die resultierende Schichtdicken-Verteilung an einem grossflächigen Glassubstrat dargestellt, welches wie folgt beschichtet wurde:

- totale Sputterleistung $p_{tot}$: 2 kW.

- Sputterzeit: 100 sec.

- Sputterrate R: 26 Å/sec., relative: 13 Å/sec. kW.

- Quelle mit sechs Targetanordnungen, woran die äussersten Anordnungen mit 10 bzw. 15 % höherer Sputterleistung betrieben wurden ($p_1$, $p_6$):

- Substratgrösse: 650 x 550 mm$^2$

In Fig. 11 sind die Randbereiche des Substrates, welche über den mit höherer Leistung betriebenen Targe-tanordnungen lagen, angeschrieben. Es ergaben sich bei ITO-Beschichtung der gemittelt 267 nm dicken Schicht Schicht-dicken-Abweichungen von $\pm$ 6,3 %.

Mit der vorliegenden Erfindung werden insbesondere folgende Nachteile vorbekannter Sputterquellen, insbesondere für grossflächige Werkstückbeschichtungen, vermieden:

- Weil erfindungsgemäss eine gleichförmige Verteilung der Prozessbedingungen über einer grossen Magnetronsputterfläche möglich ist, mit hoher Beschichtungsrate und hoher Sputterraten-Ausnutzung, ergibt sich eine hohe Wirtschaftlichkeit für die Beschichtung grossflächiger Substrate, gegebenenfalls vieler Einzelsubstrate gleichzeitig.

- Weil an der erfindungsgemässen Quelle grossflächig gleichzeitig abgestäubt wird, ergibt sich eine bessere Schichtdickenverteilung am Substrat sowie eine Verhinderung von Störfunken-Bildung (arcing).

- Weil das Problem der Reaktivgas-Verteilung und/oder der Targeterosions-Verteilung in homogenisierendem Sinne gelöst ist, können zu beschichtende Substrate wesentlich näher an der Quelle positioniert werden und mit wesentlich grösseren zu beschichtenden Flächen relativ zur Quellenfläche, was die Wirtschaftlichkeit einer Sputterbeschichtungsanlage mit einer erfindungsgemässen Quelle wesentlich erhöht.

- Das Problem an grossflächigen Targets entstehender Plasmadichte-Unterschiede zwischen Targetmitte und Targetperipherie, aufgrund fehlender Anoden in Targetmitte, wird behoben.

- Die Quelle kann flexibel durch modulare Targetanordnungen den jeweiligen Grössenanforderungen angepasst werden.

- Das Problem bei grossflächigen Targets, dass nämlich der Prozess in Targetmitte Reaktivgas-verarmt, wird gelöst, da Gaseinlässe 49 über der eigentlichen Quellenfläche verteilt vorgesehen sind.

- Weil (siehe Fig. 4) der Trägersockel (41) zwischen Prozessvakuum und Atmosphärendruck liegt, ist es nicht länger nötig, auch diese Belastung aufnehmende, dicke Kühlplatten (23) vorzusehen, womit die Quelle weniger aufwendig ist und insbesondere ein besserer Durchgriff der Felder der unter der Targetanordnung (3) vorgesehenen Magnetanordnungen (47, 43) realisiert wird.

Durch selektive Ansteuerung folgender Verteilungen:

- zeitlich und/oder örtlich, elektrischer Betrieb der Targetanordnungen

- zeitlich und/oder örtlich, magnetischer Betrieb der Targetanordnungen

- zeitlich und/oder örtlich, Gäseinlass
  ist es möglich, an grossflächigen Substraten die resultierende Schichtdickenverteilung optimal einzustellen, insbesondere homogen einzustellen.

- Aufgrund der vorgesehenen Bajonettverschlüsse im Zusammenwirken mit dem Festspannen der Targetanordnungen über den Kühlmediumsdruck ist ein äusserst einfaches und schnelles Auswechseln der Targetanordnungen möglich und eine äusserst effiziente, grossflächige Kühlung.

- Aufgrund der unterhalb der Sputterflächen vorgesehenen Bajonett-Halterungen sind keine, insbesondere keine Sputtermaterial-fremden, Halteorgane vom Prozessraum her zugänglich.


**Patentansprüche**

1. Magnetronsputterquelle, **dadurch gekennzeichnet, dass** mindestens zwei elektrisch voneinander isolierte Langtarget-Anordnungen (3) längsseits nebeneinander angeordnet sind, in einem Abstand (d), der wesentlich kleiner ist als die Breitenausdehnung (B) der Targetanordnungen (3), und dass jede der Targetanordnungen (3) einen eigenen elektrischen Anschluss (5) aufweist, wobei weiter eine Anodenanordnung (7) vorgesehen ist.

2. Quelle nach Anspruch 1, **dadurch gekennzeichnet, dass** die Anodenanordnung Anoden längsseits zwischen den Targetanordnungen und/oder stirnseits der Targetanordnungen umfasst, vorzugsweise längsseits.

3. Quelle nach Anspruch 1, **dadurch gekennzeichnet, dass** eine stationäre Magnetanordnung (47) vorgesehen ist, welche vorzugsweise einen um die Targetanordnungen umlaufenden Rahmen mit Elektro- und/oder Permanentmagneten umfasst, insbesondere bevorzugt je um die Targetanordnungen umlaufende Rahmen mit Elektro- und/oder Permanentmagneten, wobei die Magnete des oder der Rahmen bevorzugt Permanentmagnete sind.

4. Quelle nach einem der Ansprüche 1 bis 3, **dadurch gekennzeichnet, dass** unterhalb je der Targetanordnungen Magnetanordnungen vorgesehen sind, vorzugsweise solche, die über den Sputterflächen der Anordnungen je eine zeitliche Variation eines Magnetfeldmusters bilden, vorzugsweise durch Variation der Lage des Scheitels eines tunnelförmigen, umlaufenden Magnetfeldes, und dass die Magnetanordnungen durch selektiv gesteuerte und/oder bewegte Elektromagnete und/oder durch bewegte Permanentmagnete gebildet sind, vorzugsweise durch letzteres, dabei insbesondere bevorzugt durch jeweils mindestens zwei sich entlang der Targetanordnungen-Längsausdehnungen erstrekkende, getriebene und drehgelagerte Magnetwalzen (43) mit Permanent- und/oder Elektromagneten, vorzugsweise mit Permanentmagneten.

5. Quelle nach einem der Ansprüche 1 bis 4, **dadurch gekennzeichnet, dass** die Targetanordnungen (3) an einem Trägersockel (41) montiert sind und daran, je Targetanordnung (3), deren sockelseitige Flächen zu einem überwiegenden Teil bedeckende, gegen die genannte Fläche mittels Folien (37) verschlossene Kühlmedium-Kanäle (35) angeordnet sind, vorzugsweise derart, dass auf der den Targetanordnungen zugewandten Sockelseite Vakuum- und gleichzeitig auf der anderen Seite des Sockels Atmosphärendruck anlegbar ist.

6. Quelle nach einem der Ansprüche 1 bis 5, **dadurch gekennzeichnet, dass** die Targetanordnungen (3) sowie die Anodenanordnung (7), weiter gegebenenfalls der oder die stationäre Magnetanordnung, vorzugsweise der oder die Magnet-Rahmen (47) und/oder die Magnetanordnungen unterhalb der Targetanordnungen, vorzugsweise Magnetwalzen, und/oder die Kühlmediums-Kanäle (35), in bzw. an einem Teil aus elektrisch isolierendem Material, vorzugsweise aus Kunststoff, eines Trägersockels (41) aufgenommen sind und der Sockel vorzugsweise so ausgebildet ist, dass gleichzeitig targetseitig Vakuum-, aussenseitig Atmosphärendruck anlegbar ist.

7. Quelle nach Anspruch 6, **dadurch gekennzeichnet, dass** die Kühlmediums-Kanäle an ihrer Basis jeweils durch eine Metallplatte begrenzt sind.

8. Quelle nach einem der Ansprüche 1 bis 7, **dadurch gekennzeichnet, dass,** verteilt, entlang den Targetanordnungs-Längsseiten Gasaustrittsöffnungen (49) vorgesehen sind, welche mit einem Gasverteilsystem (64) kommunizieren.

9. Quelle nach einem der Ansprüche 1 bis 8, **dadurch gekennzeichnet, dass** die Targetanordnungen (3) längsseits höchstens 15 %, vorzugsweise höchstens 10 %, vorzugsweise gar höchstens 7 % ihrer Breitenausdehnung (B) beabstandet (d) sind.

10. Quelle nach einem der Ansprüche 1 bis 9, **dadurch gekennzeichnet, dass** die Targetanordnungen (3) eine Längsausdehnung (L) mindestens gleich ihrer Breitenausdehnung, vorzugsweise wesentlich länger, aufweisen, dass sie vorzugsweise beträgt

$$400 \text{ mm} \leq L \leq 2000 \text{ mm.}$$

11. Quelle nach einem der Ansprüche 1 bis 10, **dadurch gekennzeichnet, dass** die Targetanordnungen längsseits einen Abstand d von

$$1 \text{ mm} \leq d \leq 230 \text{ mm}$$

vorzugsweise von

$$7 \text{ mm} \leq d \leq 20 \text{ mm}$$

bilden.

12. Quelle nach einem der Ansprüche 1 bis 11, **dadurch gekennzeichnet, dass** die Breite B der Targetanordnungen beträgt:

$$60 \text{ mm} \leq B \leq 350 \text{ mm}$$

vorzugsweise

$$80 \text{ mm} \leq B \leq 200 \text{ mm.}$$

13. Quelle nach einem der Ansprüche 1 bis 11, **dadurch gekennzeichnet, dass** die Neuflächen der Targetanordnungen (3) entlang einer Ebene angeordnet sind.

**14.** Quelle nach einem der Ansprüche 1 bis 13, **dadurch gekennzeichnet, dass**, in einer gegebenen Raumrichtung (Z) gemessen, die Stärke des Magnetfeldes (H) entlang der Targetanordnungs-Längsausdehnung und in ihrem Längsrandbereich örtlich unterschiedlich ist.

**15.** Quelle nach einem der Ansprüche 1 bis 14, **dadurch gekennzeichnet, dass** die Targetanordnungen (3) gemeinsam einem, vorzugsweise je einem Magnet-Rahmen (47) zugeordnet sind, vorzugsweise einem oder je einem Permanentmagnet-Rahmen, und die Position und/oder die Stärke der Magnete des oder der Rahmen (47) entlang mindestens eines Teils der Targetanordnungs-Längsseiten örtlich unterschiedlich ist.

**16.** Quelle nach einem der Ansprüche 1 bis 15, **dadurch gekennzeichnet, dass** unterhalb der Targetanordnungen (3) mindestens zwei längsausgedehnte, getrieben drehgelagerte Magnet-Walzen (43) vorgesehen sind, und dass die Stärke und/oder Position von Magneten entlang mindestens eines Teils der Walzen (43) örtlich unterschiedlich ist, wobei die Magnete der Walzen vorzugsweise Permanentmagnete sind.

**17.** Quelle nach einem der Ansprüche 1 bis 16, **dadurch gekennzeichnet, dass** die Targetanordnungen (3) gemeinsam oder vorzugsweise je, von Magnet-Rahmen (47) umschlossen sind, und dass die Stärke und/oder Position der Magnete des Rahmens entlang mindestens eines Teils der Targetanordnungs-Längsseiten örtlich unterschiedlich ist, und zwar, an einer jeweiligen Targetanordnung betrachtet, im wesentlich spiegelsymmetrisch zu einer der Langtarget-Diagonalen (Di), wobei die Magnete des oder der Rahmen bevorzugterweise Permanentmagnete sind.

**18.** Quelle nach einem der Ansprüche 1 bis 17, **dadurch gekennzeichnet, dass** die Targetanordnungen mittels linearer Bajonettverschlüsse (25, 32) gehaltert sind.

**19.** Quelle nach einem der Ansprüche 1 bis 18, **dadurch gekennzeichnet, dass** mehr als zwei, vorzugsweise fünf und mehr, Targetanordnungen vorgesehen sind.

**20.** Sputterbeschichtungskammer mit einer Magnetronsputterquelle (10) nach einem der Ansprüche 1 bis 19 sowie einem beabstandet gegenüber der Magnetronsputterquelle angeordnetem Substratträger (66) für mindestens ein sputterzubeschichtendes Substrat, **dadurch gekennzeichnet, dass** für das Verhältnis ($V_{QS}$) der abgesputterten Quellenfläche $F_Q$ zur zu beschichtenden Substratoberfläche $F_S$ gilt:

$$V_{QS} \leq 3$$

vorzugsweise

$$V_{QS} \leq 2$$

vorzugsweise

$$1,5 \leq V_{QS} \leq 2.$$

**21.** Kammer nach Anspruch 20, **dadurch gekennzeichnet, dass** der Abstand (D) zwischen der Neufläche der Magnetronsputterquelle (10) und dem Substrat im wesentlichen gleich der Breite einer der Langtarget-Anordnungen (3) ist, vorzugsweise beträgt:

$$60 \text{ mm} \leq D \leq 250 \text{ mm,}$$

vorzugsweise

$$80 \text{ mm} \leq D \leq 160 \text{ mm.}$$

22. Vakuumbeschichtungsanlage mit einer Kammer nach einem der Ansprüche 20 oder 21, **dadurch gekennzeichnet, dass** die Targetanordnungen (3) mit voneinander unabhängig ansteuerbaren elektrischen Generatoren (62) verbunden sind.

23. Anlage nach Anspruch 22, **dadurch gekennzeichnet, dass** mehr als zwei der Targetanordnungen (3) vorgesehen sind und mindestens zwei der vorgesehenen Targetanordnungen (3) mit den Ausgängen eines gemeinsamen AC-Generators (15, 17) verbunden sind.

24. Anlage nach Anspruch 22, **dadurch gekennzeichnet, dass** mindestens einer der vorgesehenen Generatoren (9, 62) ein DC-Generator, ein AC-Generator oder ein Generator für die Abgabe von DC-überlagertem AC oder gepulstem DC ist, oder dass mindestens einer der Generatoren ein DC-Generator ist und über eine Choppereinheit mit der Targetanordnung (3) verbunden ist.

25. Anlage nach einem der Ansprüche 22 bis 24, **dadurch gekennzeichnet, dass** längsseits mindestens zwischen einem Teil der Targetanordnungen Gasauslassöffnungen (49) vorgesehen sind, welche mit einem Reaktivgastank und/oder einem Arbeitsgastank (53) verbunden sind.

26. Anlage nach Anspruch 25, **dadurch gekennzeichnet, dass** mindestens ein Teil der entlang der Targetanordnungen (3) verteilt vorgesehenen Gasauslässe (49) unabhängig von andern bezüglich Gasfluss (51, 64) steuerbar ist.

27. Verfahren zum Betrieb einer Anlage nach einem der Ansprüche 22 bis 26 mit mindestens drei Langtarget-Anordnungen (3),
**dadurch gekennzeichnet, dass** die seitlich aussenliegenden Targetanordnungen mit mehr Sputterleistung, vorzugsweise mit 5 bis 35 % mehr Sputterleistung betrieben werden, vorzugsweise mit 10 bis 20 % bezüglich der innenliegenden Targetanordnungen.

28. Verfahren zum Betrieb einer Anlage nach einem der Ansprüche 22 bis 26, bei der je unterhalb der Targetanordnungen eine örtlich verschiebliche und/oder zeitlich gesteuerte Magnetanordnung, vorzugsweise gebildet durch jeweils mindestens zwei drehgetrieben gelagerte Permanentmagnet-Walzen (43), vorgesehen ist, **dadurch gekennzeichnet, dass** man das an den Targetanordnungen erzeugte Magnetfeld in einem Takt von 1 bis 4 Hz variiert, vorzugsweise die beiden Walzen (43) im Pendelbetrieb betreibt, mit einer Pendelfrequenz von 1 bis 4 Hz, vorzugsweise mit ca. 2 Hz, vorzugsweise mit einer Drehwinkelamplitude $\varphi \leq \pi/4$.

29. Verfahren nach einem der Ansprüche 27 oder 28, **dadurch gekennzeichnet, dass** man durch Steuerung der elektrischen Speisung je der Targetanordnungen und/oder der Gaseinlass-Verteilung und/oder der Magnetfeldverteilung die Verteilung der Schichtdicke am Substrat über dessen Fläche einstellt, vorzugsweise genähert homogen einstellt.

30. Verfahren nach einem der Ansprüche 27 bis 29, **dadurch gekennzeichnet, dass** man die Magnetronsputterquelle mit einer Leistungsdichte p von

$$1 \text{ W/cm}^2 \leq p \leq 30 \text{ W/cm}^2$$

betreibt,

dass man vorzugsweise für reaktives Sputterbeschichten aus vorzugsweise metallischen Targets, insbesondere für solches ITO-Sputterbeschichten, p wie folgt wählt:

$$1 \ W/cm^2 \ \leq \ p \ \leq \ 5 \ W/cm^2,$$

für Metallsputterbeschichten:

$$15 \ W/cm^2 \ \leq \ p \ \leq \ 30 \ W/cm^2.$$

31. Langmagnetronquelle mit einer im wesentlichen rechteckförmigen Targetanordnung, darunter einem zeitlich variablen, vorzugsweise bewegten Magnet-System, **dadurch gekennzeichnet, dass** die Targetanordnung einen Magnet-Rahmen (47), vorzugsweise einen Permanentmagnet-Rahmen umfasst, wobei die in einer gegebenen Raumrichtung (Z) gemessene Feldstärke des Magnet-Rahmens entlang den Targetanordnungs-Längsseiten (x) örtlich unterschiedlich ist.

32. Quelle nach Anspruch 31, **dadurch gekennzeichnet, dass** die Feldstärke an beiden Targetanordnungs-Längsseiten im wesentlichen spiegelsymmetrisch zur Diagonale der Anordnung örtlich unterschiedlich ist.

33. Quelle nach einem der Ansprüche 31 oder 32, **dadurch gekennzeichnet, dass** das Magnet-System unterhalb der Targetanordnung mindestens zwei sich in Target-Längsrichtung erstreckende, getrieben drehgelagerte Magnet-Walzen (43) umfasst.

34. Verwendung der Magnetronsputterquelle nach einem der Ansprüche 1 bis 19 oder der Kammer nach einem der Ansprüche 20, 21 oder der Anlage nach einem der Ansprüche 22 bis 26 oder der Quelle nach einem der Ansprüche 31 bis 33 für reaktives Sputterbeschichten, vorzugsweise ab metallischen Targets, insbesondere für derartiges Beschichten mit Indium-Zinn-Oxid (ITO).

35. Verwendung der Magnetronsputterquelle nach einem der Ansprüche 1 bis 19 oder der Kammer nach einem der Ansprüche 20, 21 oder der Anlage nach einem der Ansprüche 22 bis 26 oder der Quelle nach einem der Ansprüche 31 bis 33 für die Beschichtung von Flachpannel-Display-Substraten, insbesondere von TFT- oder PDP-Pannel-Substraten, z.B. aus Glas, insbesondere mit einer reaktiv abgelegten Schicht, insbesondere einer ITO-Schicht.

36. Verwendung nach Anspruch 35 für Substrate mit einer zu beschichtenden Fläche $F_S$:

$$F_s \geq \ 900 \ cm^2.$$

FIG.1

FIG.2

FIG.3

10

B     d

49   35   $3_{a2}$   23   20   $3_a$   $3_{a1}$   39   20   $3_{b2}$   $3_b$   $3_{b1}$

37

$H_Z$

$\omega_{43}$

51

$Z_4, 53$

47   43   45   41   11   51   51

49

53

FIG.4

EP 2 119 810 A2

FIG.5

FIG.6

FIG.7

FIG.8

FIG.9

EP 2 119 810 A2

FIG.10

MAPPING : ITO 550 x 650   STRUCTURE : ITO

POINTS

    Measured:      480

    Rejected:       0

THICKNESS [nm]

    Actual:

    Min   : ▽ :     250.1

    Max  : ▲ :     283.7

    Average:     266.6

UNIFORMITY [%]

    [+/-%] :      6.3

$P_{tot}$ = 2 kW

t = 100 sec

R = 26 Å/sec

$R_{rel}$ = 13 Å/seckW

Quelle 6: + 10% Leistung

Quelle 1: + 15% Leistung

① :  281.6 nm      ⑤ :  264.8 nm

② :  277.4 nm      ⑥ :  260.6 nm

③ :  273.2 nm      ⑦ :  256.4 nm

④ :  269.0 nm      ⑧ :  252.2 nm

FIG.11

EP 2 119 810 A2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0603587 A
- US 5399253 A
- EP 0564789 A
- US 08887091 B
- CH 687427 A